# EUROPEAN PATENT APPLICATION

(11) **EP 1 772 512 A2**
(43) Date of publication of application: **11.04.2007**
(21) Application number: 06255153.6
(22) Date of filing: 05.10.2006
(51) Int. Cl.: C10M 135/18, C10M 137/10, C10M 125/22, C10M 141/08, C10M 141/10, C23C 14/06, C23C 16/26, F16C 33/04, C10N 10/12

(54) **Sliding structure and sliding method**

(30) Priority: 05.10.2005 JP 2005292846
(71) Applicant: TOYOTA JIDOSHA KABUSHIKI KAISHA, Toyota-shi, Aichi-ken 471-8571 (JP)
(72) Inventor: Nakagawa, Ikuo, Toyota-shi, Aichi 471-8571 (JP); Ogawa, Masaaki, Toyota-shi, Aichi 471-8571 (JP); Fuwa, Yoshio, Toyota-shi, Aichi 471-8571 (JP); Ozaki, Yoshinori, Toyota-shi, Aichi 471-8571 (JP)
(74) Representative: Duckworth, Timothy John

(57) **Abstract**

According to the present invention, a sliding structure whereby wear resistance of a pair of sliding members that are able to slide relative to each other is improved and the friction coefficient can be reduced is provided.

The sliding structure in which a lubricating oil is fed between sliding faces of a pair of sliding members that are able to slide relative to each other such that at least one of the members is allowed to slide is provided. The sliding structure is characterized in that: an amorphous carbon film is formed on the sliding face of at least one sliding member so as to result in a D to G band integrated intensity ratio in the Raman spectrum of between 1.5 and 2.0; and the lubricating oil existing between the sliding faces contains a compound comprising at least molybdenum and sulfur so as to result in a molybdenum content of not less than 400 ppm relative to the lubricating oil.

## Description

### BACKGROUND OF THE INVENTION

### Field of the Invention

The present invention relates to a sliding structure, in which a lubricating oil is fed between sliding faces of a pair of sliding members that are able to slide relative to each other such that at least one of the sliding members is allowed to slide. Particularly, the present invention relates to a sliding structure in which wear resistance and low-friction characteristics of the sliding faces of such members are improved.

### Background Art

Heretofore, sliding members have been used in various types of devices such as engines and transmissions for automobiles. There have been various forms of ongoing research and development aimed at decreasing sliding resistance between sliding members for energy loss reduction so as to meet the future fuel efficiency requirements for the purpose of global environmental preservation. For instance, one example of such research and development relates to a technology of coating sliding faces of sliding members, whereby wear resistance of such sliding members is improved and low-friction characteristics are imparted to the members. In recent years, as a material used for coating, hard carbon films made of diamond-like carbon (DLC) and the like have been gaining attention. Meanwhile, when sliding members are allowed to slide, it is very important to select a lubricating oil/grease for the purpose of achieving hydrodynamic lubrication based on consideration of the material quality, surface roughness, and use environments of such members. This is because a lubricating oil or a grease that are supplied to sliding faces of sliding members significantly influence the sliding properties thereof.

For instance, an example of such sliding members has been suggested in which a lubricating oil containing molybdenum dithiocarbamate serving as an ashless friction modifier is used on sliding faces of a diamond-like carbon (DLC) material and an iron-based material (see Patent Document 1).

[Patent Document 1] JP Patent Publication (Kokai) No. 2003-238982 A

### SUMMARY OF THE INVENTION

However, in the case of the sliding members described above, molybdenum dithiocarbamate is added to a lubricating oil for the purpose of forming a molybdenum disulfide coating on the surfaces of the sliding members at the time of sliding so as to improve wear resistance and low-friction characteristics. However, it cannot be said that such molybdenum-based solid lubricant always acts effectively on DLC-coated sliding members. Even if such lubricating oil is used, it cannot exert an effect that simultaneously improves wear resistance and low-friction characteristics in severe use environments in automobiles and the like, unless various conditions are considered.

The present invention has been made under the above circumstances. It is an objective of the present invention to provide a sliding structure in which improved wear resistance and a decreased friction coefficient for a pair of sliding members that slide relative to each other can be achieved.

Inventors of the present invention carried out many experiments and studies so as to attain above objectives. As a result, the inventors of the present invention have found that sliding members are significantly improved in terms of wear resistance and low-friction characteristics by allowing molybdenum disulfide serving as a solid lubricant to act on the surfaces of DLC (amorphous carbon) films on the members at the time of sliding under the condition that the ratio of the diamond structure composed of sp³ bonds to the graphite structure composed of sp² bonds to the amorphous structure in which these bonds and hydrogen bonds exist together in a DLC film and the ratio of molybdenum disulfide to the totality of a lubricating oil satisfy given conditions.

The present invention has been made based on the aforementioned new findings obtained by the inventors of the present invention. The present invention relates to a sliding structure in which a lubricating oil is fed between sliding faces of a pair of sliding members that are able to slide relative to each other such that at least one of the members is allowed to slide. The sliding structure is characterized in that: an amorphous carbon film is formed on the sliding face of at least one sliding member so as to result in a D to G band integrated intensity ratio in the Raman spectrum of between 1.5 and 2.0; and the lubricating oil existing between the sliding faces contains a compound comprising at least molybdenum and sulfur so as to result in a molybdenum content of not less than 400 ppm relative to the lubricating oil.

The "Raman spectrum" of the present invention indicates a spectrum of Raman scattered light that has a wavelength different from that of incident light when an object (amorphous carbon film) is irradiated with monochromatic light such as laser beam using a general Raman spectrometer. In general, the structure of such object can be identified based on the scattered light spectrum (intensity) and the difference between the Raman scattered light frequency and the incident light frequency (Raman shift).

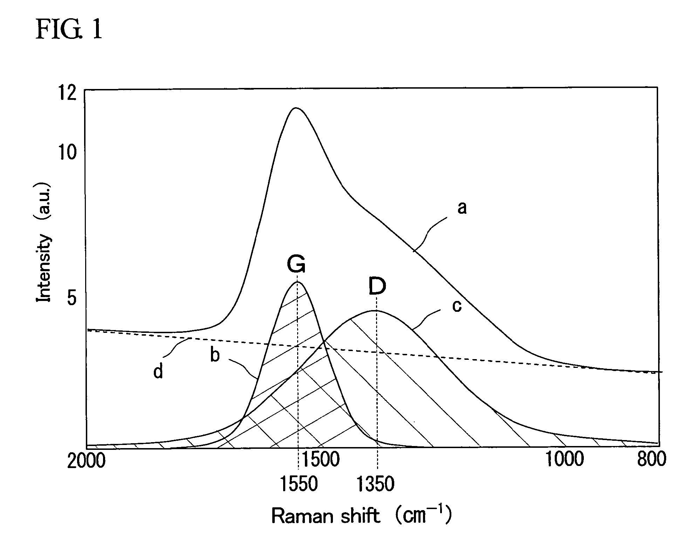

Herein, when structural analysis of an amorphous carbon film is carried out based on Raman spectral analysis, an amorphous carbon film does not have a certain crystal structure so that Raman spectral peaks appear at Raman shifts of about 1350 cm⁻¹ and 1550 cm⁻¹, in general. The "G band" of the present invention has a Raman peak shift of about 1550 cm⁻¹, indicating that the band is derived from the graphite structure of the amorphous carbon film (see line b of fig. 1 in Examples described below). The "D band" of the present invention has a Raman peak shift of about 1350 cm⁻¹, indicating that the band is derived from the amorphous structure of the amorphous carbon film (see line c of fig. 1 in Examples described below). In addition, the D to G band integrated intensity ratio D/G (the ratio of the hatched area below line c to the hatched area below line b in Example 1 described below) indicates the ratio of the amorphous structure contained in a DLC (amorphous carbon) film.

For instance, when the integrated intensity ratio D/G is large (the ratio of the amorphous structure in a film is large), the amorphous structure tends to transform to graphite at the time of sliding as described above (as a result of promoted graphitization). Thus, the friction coefficient of the film can be decreased; however, sufficient wear resistance cannot be maintained due to weakened bonds throughout the entire film.

In the case of the sliding structure of the present invention, a compound comprising sulfur and molybdenum, which is contained in the lubricating oil, transforms to molybdenum disulfide having a layer structure form (when the compound is molybdenum disulfide, the compound remains as is) at the time of sliding. In addition, molybdenum disulfide is suitable for an amorphous carbon film that has the D to G band integrated intensity ratio D/G of between 1.5 and 2.0 upon Raman spectral analysis, so that wear resistance and low-friction characteristics of sliding members can be improved. That is, based on the aforementioned reasons, when the integrated intensity ratio D/G is less than 1.5, the friction coefficient cannot be sufficiently reduced even with the existence of molybdenum disulfide on sliding faces. Further, when the integrated intensity ratio D/G exceeds 2.0, wear resistance of sliding members cannot be sufficiently maintained.

Alternatively, additional elements such as Si, Ti, Cr, Fe, W, and B may be contained in the amorphous carbon film. By adding such elements, film surface hardness can be adjusted.

Further, in order to avoid decreased adhesion strength between the amorphous carbon film and a substrate, preferably, the amorphous carbon film is formed by laminating a surface hard layer composed of amorphous carbon material and an adhesion layer comprising elements selected from group consisting of Cr, Ti, W, Ni, and any combination thereof. When such adhesion layer is provided, adhesion between the surface hard layer and the substrate is improved so that detachment of the surface hard layer from the substrate can be prevented at the time of sliding.

In a further preferred embodiment, an interlayer is further provided between the surface hard layer and the adhesion layer of such amorphous carbon film. The aforementioned elements are added to amorphous carbon material such that the elemental composition of the interlayer becomes closer to that of the adhesion layer toward the adhesion layer. Thus, when elements selected from the group consisting of Cr, Ti, W, Ni, and any combination thereof are added to amorphous carbon material in such a gradated manner, the interface of the interlayer adjacent to the surface hard layer has a composition similar or equivalent to the composition of the surface hard layer. Meanwhile, the interface of the interlayer adjacent to the adhesion layer has a composition similar or equivalent to that of the adhesion layer. Thus, such interlayer causes further improvement of adhesion between the surface hard layer and the adhesion layer, resulting in improved film adhesion strength.

In another further preferred embodiment, an amorphous carbon film is formed by a plasma physical vapor deposition method (plasma PVD), a plasma chemical vapor deposition method (plasma CVD), or an arc ion plating method. Specifically, in order to form an amorphous carbon film having the integrated intensity ratio D/G described above, these deposition methods are preferable. However, as long as the integrated intensity ratio D/G is satisfied, in particular, a physical vapor deposition method (PVD) utilizing vacuum deposition, sputtering, or the like, and also a chemical vapor deposition method (CVD) excluding plasma treatment may be used for deposition.

The aforementioned compound must be contained in a lubricating oil so as to result in a molybdenum content in the compound of not less than 400 ppm relative to the lubricating oil. When the molybdenum content is less than 400 ppm, friction coefficient cannot be sufficiently reduced. Preferably, such compound is contained in a lubricating oil so as to result in a molybdenum content in the compound of not more than 800 ppm relative to the lubricating oil. Even when the molybdenum content in the compound is more than 800 ppm relative to the lubricating oil, further effects cannot be expected, so that such content is not desirable in terms of cost increase.

Further, the aforementioned compound contained in the lubricating oil is preferably selected from the group consisting of molybdenum dialkyldithiocarbamate (Mo-DTC), molybdenum dithiophosphate (Mo-DTP), molybdenum disulfide, and any combination thereof. Such compound acts as a solid lubricant at the time of sliding. Molybdenum disulfide serving as a solid lubricant can improve wear resistance and low-friction characteristics of the sliding members. Then, when such compound is used in an engine oil or the like, organic molybdenums such as molybdenum dialkyldithiocarbamate and molybdenum dithiophosphate that can be dispersed in a lubricating oil are preferable. Particularly, in view of general-purpose properties, cost, and the like, molybdenum dialkyldithiocarbamate is further preferable. The structure of alkyl in a molecule of the compound differs depending on production methods; however, a similar effect can be expected as long as the aforementioned molybdenum content in a lubricating oil is achieved. Thus, specific examples of molybdenum dialkyldithiocarbamate include sulfurized molybdenum dibutyldithiocarbamate, sulfurized molybdenum dipentyldithiocarbamate, sulfurized molybdenum dihexyldithiocarbamate, sulfurized molybdenum diheptyldithiocarbamate, sulfurized molybdenum dioctyldithiocarbamate, sulfurized molybdenum dinonyldithiocarbamate, sulfurized molybdenum didecyldithiocarbamate, sulfurized molybdenum diundecyldithiocarbamate, molybdenum didodecyldithiocarbamate, and molybdenum ditridecyldithiocarbamate.

Further, a base oil of a lubricating oil existing between a pair of the sliding members is not particularly limited as long as it contains a compound as described above. Examples thereof are not particularly limited to mineral oils, synthetic oils, and the like. Such base oil can be used in a bearing oil, a gear oil, and an engine oil. In addition, as long as the aforementioned composition is obtained, an antioxidant, an antiwear agent, an extreme pressure agent, a friction modifier, a metal deactivator, a cleaning agent, a rust preventive, an antifrothing agent, or the like can be adequately added to a lubricating oil for the purpose of maintaining the performance thereof. Instead of a lubricating oil, for example, a grease in which a thickener is dispersed in a base oil containing molybdenum dialkyldithiocarbamate can exert a similar effect.

In accordance with the present invention, a sliding method described below is also disclosed as a preferred example of the sliding method of the aforementioned sliding structure. The method wherein at least one member of a pair of sliding members is allowed to slide while a lubricating oil is fed between sliding faces of the sliding members. The method is characterized in that: an amorphous carbon film is formed on the sliding face of at least sliding member so as to result in a D to G band integrated intensity ratio in the Raman spectrum of between 1.5 and 2.0 and the lubricating oil contains a compound comprising at least molybdenum and sulfur so as to result in a molybdenum content of not less than 400 ppm relative to the lubricating oil. Such lubricating oil preferably contains a compound selected from the group consisting of molybdenum dialkyldithiocarbamate, molybdenum dithiophosphate, molybdenum disulfide, and any combination thereof. Such compound is preferably contained in the lubricating oil, resulting in the molybdenum content in the compound of not more than 800 ppm relative to the lubricating oil. Thus, molybdenum disulfide serving as a solid lubricant effectively acts on the surface of the amorphous carbon film so that the friction coefficient is reduced and wear resistance is improved, leading to the obtaining of long-lived sliding members.

In addition, examples of methods of lubrication using such lubricating oil include circulating lubrication, mist lubrication, and bath lubrication using an oil bath. Such methods are not particularly limited as long as the lubricating oil can be fed between sliding members at the time of sliding.

In accordance with the present invention, the friction coefficient between the sliding members can be reduced and wear resistance of the sliding members can be improved. As a result, with use of the sliding mechanism of the present invention, lowered friction with respect to a sliding member results in a running cost reduction for an apparatus, and improved wear resistance of the members can realize a long-lived apparatus.

### BRIEF DESCRIPTION OF THE DRAWINGS

Fig. 1 shows measurement results of D and G bands in the Raman spectrum in example 1.
Fig. 2 shows results of a frictional wear test of the sliding structures of Examples 1 and 2 and Comparative examples 1 to 5.
Fig. 3 shows results of a frictional wear test of the sliding structures of Examples 3 to 6 and Comparative examples 6 and 7.
Fig. 4 shows results of a friction test of the sliding structures of Examples 7 and 8 and Comparative examples 8, 11, and 12.
Fig. 5 shows results of a wear test of the sliding structures of Examples 7 and 8 and Comparative examples 8 to 11.
Fig. 6 explains a frictional wear test.

### DESCRIPTION OF THE PREFERRED EMBODIMENTS

### [Examples]

Hereafter, the present invention will be described with reference to the following examples.

### [Example 1]

### (Sliding member)

A block test piece and a ring test piece that serve as a pair of sliding members in the sliding structure of the present invention were produced in the manner described below.

Block test piece: As a substrate on which an amorphous carbon film is formed, stainless steel (SUS440C; JIS) 15.7 × 10.0 × 6.3 mm in dimensions having as its surface roughness a center line average roughness of Ra 0.05 µm was prepared. As shown in fig. 1, an amorphous carbon film was formed on the surface of the substrate (on the 15.7 × 6.3 mm side) by the plasma PVD method while adjusting the carrier gas flow rate, the applied plasma voltage, the temperature, and the like in a manner such that the D (line c in fig. 1) to G (line b in fig. 1) band integrated intensity ratio in the Raman spectrum (ratio of a hatched area below line c to a hatched area below line b) became 1.58 (see tables 1 and 2). In addition, the total intensity of scattered light relative to incident light shown as line a of fig. 1 is obtained by combining the Raman scattering intensities shown as lines b and c in fig. 1 and the Rayleigh scattering intensity shown as line d in fig. 1.

Ring test piece: A ring test piece made of SAE 4620 having a diameter of 35.0 mm and a thickness of 8.7 m was produced. In addition, the surface roughness of the outer peripheral surface of the piece was determined to be Ra 0.25 µm.

### (Lubricating oil)

Molybdenum dialkyldithiocarbamate (Mo-DTC; equivalent to SAKURA-LUBE 100 (sulfurized molybdenum dihexyldithiocarbamate) produced by Asahi Denka Kogyo KK) was added to a base oil (commercially available engine oil; SAE viscosity grade: 5W-30), resulting in a molybdenum content in a lubricating oil of 700 ppm. Thus, a lubricating oil was obtained.

### (Frictional wear test)

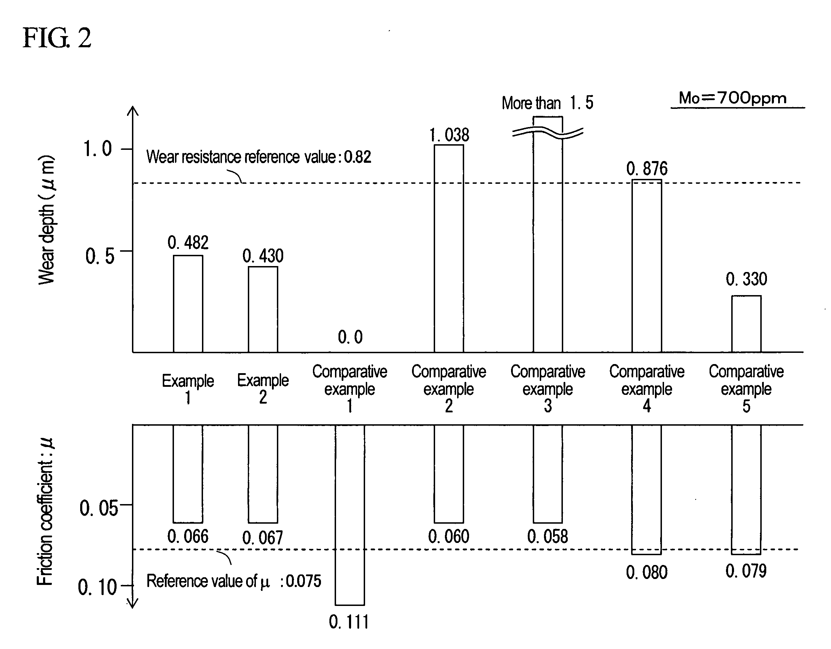

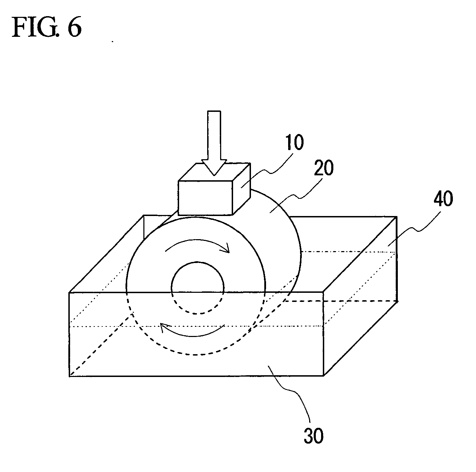

As shown in fig. 6, a frictional wear test (block-on-ring test: LFW-1 test) was conducted using a combination of a block test piece 10, a ring test piece 20, and a lubricating oil 30 described above. Specifically, a continuous test was performed for 30 minutes in the following manner: oil bath 40 is filled with the lubricating oil 30 such that a part of the ring test piece 20 was immersed in the lubricating oil 30; the ring test piece 20 was rotated therein at 160 rpm (circumferential speed: 0.3 m/s) while keeping the oil temperature at 80°C such that an oil coating was formed on the surface of the test piece; and the block test piece 10 was allowed to come into contact with outer peripheral surface of the ring test piece 20 in a state wherein 30 kgf (320 MPa) was loaded thereon. At such time, the rotational resistance (sliding resistance) to the ring test piece 20 was detected by a load cell attached to an apparatus such that the friction coefficient was determined. Then, the wear depth of the block test piece after the termination of the test was measured as the wear volume. The results are shown in table 2 and fig. 2.

### [Example 2]

After a substrate was produced as with the case of Example 1, a block test piece was produced in a manner such that an amorphous carbon film was formed on the surface of the substrate by the plasma CVD method while adjusting the concentration and the flow rate of hydrocarbon gas, the applied plasma voltage, the temperature of the substrate, and the like, resulting in a D to G band integrated intensity ratio in the Raman spectrum of 1.79 (see tables 1 and 2).

In addition, a ring test piece and lubricating oil were provided as with the case of Example 1. As with the case of Example 1, a frictional wear test was conducted so as to determine the friction coefficient and the wear volume. The results are shown in table 2 and fig. 2.

### [Comparative example 1]

After a substrate was produced as with the case of Example 1, a block test piece was produced in a manner such that an amorphous carbon film was formed on the surface of the substrate by the arc ion plating method while adjusting the arc discharge voltage, the temperature of the substrate, and the like, resulting in a D to G band integrated intensity ratio in the Raman spectrum of 1.10 (see tables 1 and 2).

In addition, a ring test piece and a lubricating oil were provided as with the case of Example 1. As with the case of Example 1, a frictional wear test was conducted so as to determine the friction coefficient and the wear volume. The results are shown in table 2 and fig. 2.

### [Comparative example 2]

After a substrate was produced as with the case of Example 1, a block test piece was produced in a manner such that an amorphous carbon film was formed on the surface of the substrate by the unbalanced magnetron sputtering method while adjusting the concentration and the flow rate of hydrocarbon gas, the bias voltage, the temperature of the substrate, and the like, resulting in a D to G band integrated intensity ratio in the Raman spectrum of 2.11 (see tables 1 and 2).

In addition, a ring test piece and a lubricating oil were provided as with the case of Example 1. As with the case of Example 1, a frictional wear test was conducted so as to determine the friction coefficient and the wear volume. The results are shown in table 2 and fig. 2.

### [Comparative example 3]

After a substrate was produced as with the case of Example 1, a block test piece was produced in a manner such that an amorphous carbon film was formed on the surface of the substrate by the plasma CVD method while adjusting the concentration and the flow rate of hydrocarbon gas, the applied plasma voltage, the temperature of the substrate, and the like, resulting in a D to G band integrated intensity ratio in the Raman spectrum of 4.53 (see tables 1 and 2). In addition, a ring test piece and lubricating oil were provided as with the case of Example 1. A frictional wear test was conducted so as to determine the friction coefficient and the wear volume in the manner used in Example 1. The results are shown in table 2 and fig. 2.

### [Comparative example 4]

After a substrate was produced as with the case of Example 1 as a block test piece, on which the substrate amorphous carbon film was not formed (see tables 1 and 2). In addition, a ring test piece and a lubricating oil that were the same as those used in Example 1 were provided. As with the case of Example 1, a frictional wear test was conducted so as to determine the friction coefficient and the wear volume. The results are shown in table 2 and fig. 2.

### [Comparative example 5]

After a substrate was produced as with the case of Example 1, a block test piece was produced in the following manner: a chromium nitride (Cr₂N) film was formed on the surface of the substrate in accordance with a conventional method (see tables 1 and 2). In addition, a ring test piece and lubricating oil that were the same as those used in Example 1 were provided. As with the case of Example 1, a frictional wear test was conducted so as to determine the friction coefficient and the wear volume. The results are shown in table 2 and fig. 2.

In addition, table 2 and fig. 2 show, as references, the reference value of friction coefficient at which level expression of fuel efficiency-improving effects can be expected at a sliding part of an engine or the like and the reference value of wear depth at which level durability can be secured at a sliding part of an engine or the like.

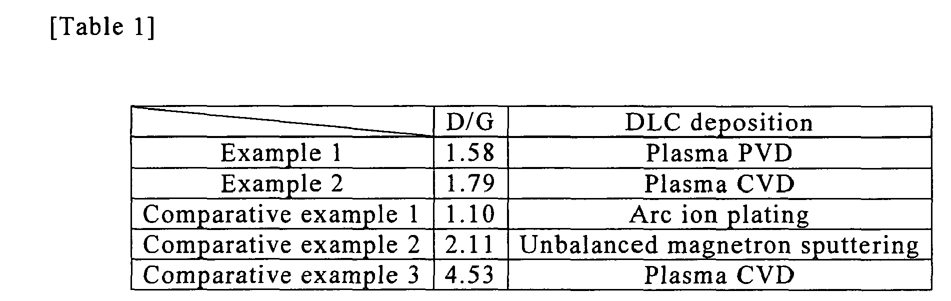

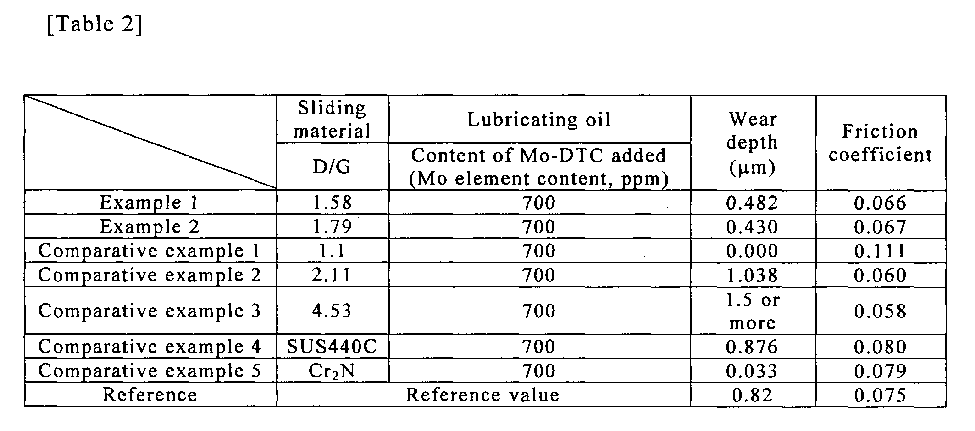

### [Result 1]

In the cases of the sliding members of Examples 1 and 2, both wear depth and friction coefficient were below the reference values. However, in the cases of sliding members of comparative examples 1 to 5, at least either wear depth or friction coefficient became larger than the reference value.

### [Evaluation 1]

Based on results of Examples 1 and 2 and Comparative examples 1-3, it is considered that, in the case of the sliding member used in Comparative example 1, the friction coefficient became larger compared with Examples 1 and 2 because the D to G band integrated intensity ratio D/G in the Raman spectrum was smaller compared with Examples 1 and 2. Also, in the cases of the sliding members used in Comparative examples 2 and 3, it is considered that the wear depth became larger compared with Examples 1 and 2 because the integrated intensity ratio D/G was larger compared with Examples 1 and 2. Thus, it is considered that a preferred integrated intensity ratio D/G of amorphous carbon film is between 1.5 and 2.0 when a lubricating oil is supplied between sliding members.

Specifically, when the integrated intensity ratio D/G is less than 1.5, an amorphous carbon film has a less amorphous structure, resulting in a decreased amount of amorphous carbon, which transforms to graphite that contributes to the improvement of lubricity at the time of sliding. Thus, it is considered that the friction coefficient cannot be sufficiently lowered even with the action of a solid lubricant. Meanwhile, when the integrated intensity ratio D/G exceeds 2.0, an amorphous structure tends to transform to a graphite structure at the time of sliding. As the integrated intensity ratio D/G becomes larger, the degree of amorphous structure becomes higher so that an amorphous structure transforms to a graphite structure at the time of sliding, resulting in a decreased friction coefficient. However, bonds throughout the entire film become weakened so that sufficient wear resistance cannot be obtained.

### [Evaluation 2]

Based on the results of Examples 1 and 2 and Comparative examples 4 and 5, it cannot be said that the friction coefficient can be sufficiently lowered at the time of sliding even in a case where Mo-DTC is added to a lubricating oil and molybdenum disulfide serving as a solid lubricant acts at the time of sliding. In addition, even with a coating of chromium nitride, it cannot be said that the friction coefficient can be significantly lowered as a result of a synergistic effect of chromium nitride and molybdenum disulfide. Thus, it is considered that molybdenum disulfide is suitable for an amorphous carbon film having a D to G band integrated intensity ratio D/G in the Raman spectrum of between 1.5 and 2.0. Therefore, molybdenum disulfide can improve the wear resistance and low-friction characteristics of a sliding member.

In addition, if molybdenum disulfide serving as a solid lubricant acts on sliding faces at the time of sliding, it is considered that the same effect can be obtained when other organic molybdenums such as molybdenum dithiophosphate (Mo-DTP) are added to a lubricating oil. Further, also when molybdenum disulfide is added to a lubricating oil, a similar effect can be expected.

### [Examples 3 to 6]

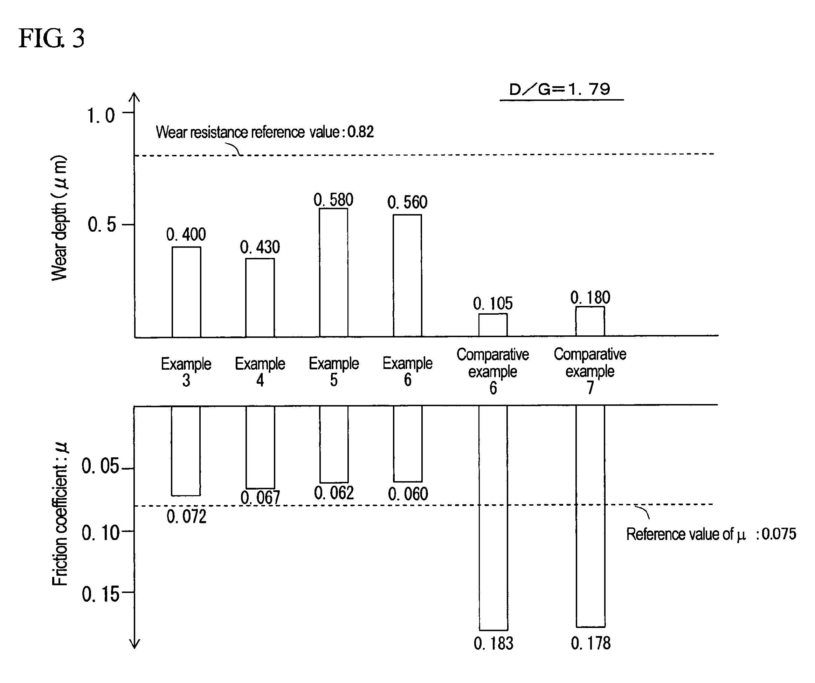

A block test piece and a ring test piece were provided as with the case of Example 2, and lubricating oils to be fed between them were also provided. Examples 3 to 6 were different from Example 2 in that the lubricating oils used in Examples 3 to 6 contained Mo-DTC in a manner such that the molybdenum contents in the lubricating oils became 400 ppm, 700 ppm, 800 ppm, and 900 ppm, respectively. Also, as with the case of Example 2, a frictional wear test was conducted so as to determine the friction coefficient and the wear volume in Examples 3 to 6. In addition, Example 4 was conducted under the same conditions as in Example 2. The results are shown in table 3 and fig. 3.

### [Comparative examples 6 and 7]

A block test piece and a ring test piece were provided as with the case of Example 3, and lubricating oils to be fed between them were also provided. Comparative examples 6 and 7 were different from Example 3 in that the lubricating oils used in Comparative examples 6 and 7 contained Mo-DTC in a manner such that the molybdenum contents in the lubricating oils became 0 ppm and 300 ppm, respectively. Also, as with the case of Example 3, a frictional wear test was conducted so as to determine the friction coefficient and the wear volume. The results are shown in table 3 and fig. 3.

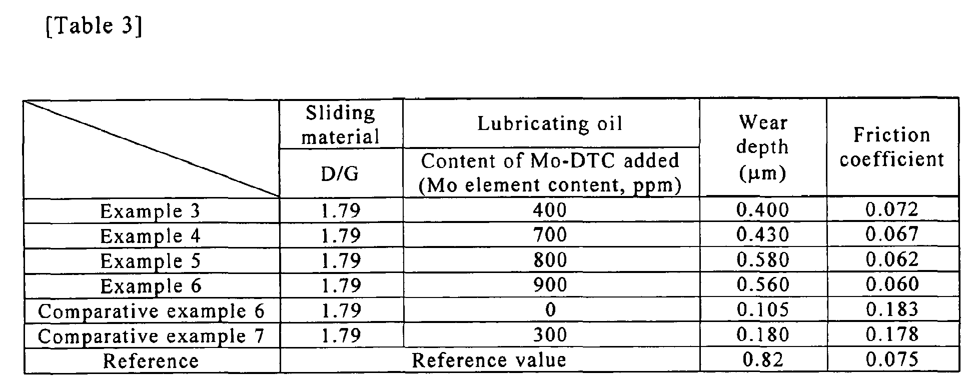

### [Result 2]

In the cases of the sliding members of Examples 3 to 6, both wear depth and friction coefficient were below the respective reference values. However, in the cases of the sliding members of Comparative examples 6 and 7, the friction coefficient exceeded the reference value.

### [Evaluation 3]

Based on the results of Examples 3 to 6 and Comparative examples 6 and 7, in the cases of the sliding members of Comparative examples 6 and 7, it is considered that the friction coefficient could not be lowered due to the low molybdenum content in the lubricating oil, even though the members were coated with an amorphous carbon film having a D to G band integrated intensity ratio D/G of between 1.5 and 2.0. Thus, molybdenum must be contained in a lubricating oil so as to result in a molybdenum content in a lubricating oil of not less than 400 ppm. When the molybdenum content is less than 400 ppm, the friction coefficient cannot be sufficiently lowered. In addition, even when the molybdenum content in the compound was more than 800 ppm relative to the lubricating oil, the friction coefficient was not sufficiently lowered. Thus, in view of the cost of lubricating oil, it is considered that the preferred molybdenum content in a lubricating oil is not more than 800 ppm.

### [Example 7]

### <Examples 7-1 to 7-4>

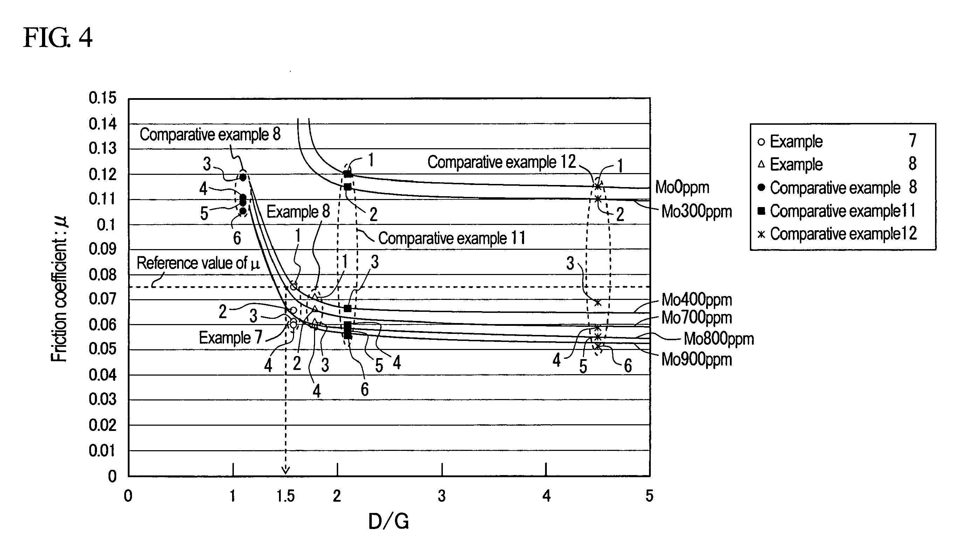

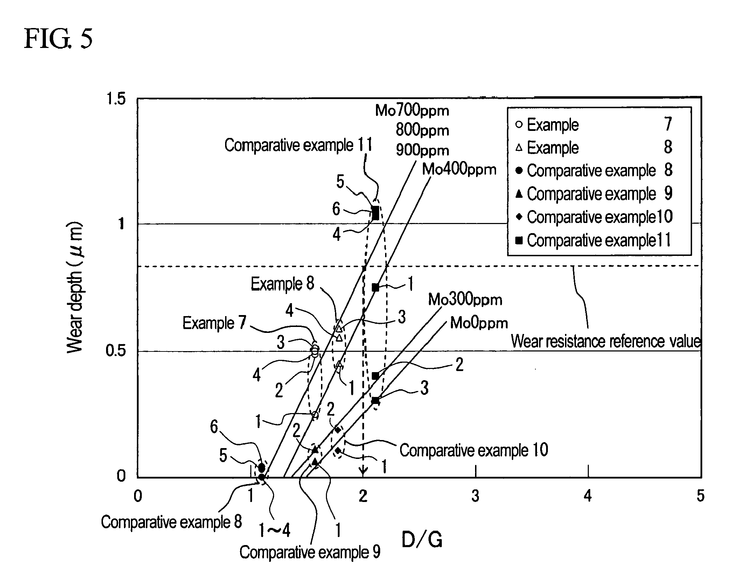

Siding members were produced as with the case of Example 1 and lubricating oils to be fed between them were provided. Examples 7-1 to 7-4 were different from Example 1 in that the lubricating oils used in Examples 7-1 to 7-4 contained Mo-DTC in a manner such that the molybdenum contents in the lubricating oils became 400 ppm, 700 ppm, 800 ppm, and 900 ppm, respectively. Also, as with the case of Example 1, a frictional wear test was conducted so as to determine the friction coefficient and the wear volume in Examples 7-1 to 7-4. In addition, Example 7-2 was conducted under the same conditions as in Example 1. The results are shown in table 4 and figs. 4 and 5.

### [Example 8]

### <Examples 8-1 to 8-4>

Examples 8-1 to 8-4 correspond to the aforementioned Examples 3 to 6 in that order. The measurement results of the friction coefficient and the wear volume are shown in table 4 and figs. 4 and 5.

### [Comparative example 8]

### <Comparative examples 8-1 to 8-6>

Sliding members were produced as with the case of Example 7, and lubricating oils to be fed between them were provided. Comparative examples 8-1 to 8-6 were different from Example 7 in that an amorphous carbon film was formed by the arc ion plating method (under the same deposition conditions as in Comparative example 1 above), resulting in a D to G band integrated intensity ratio in the Raman spectrum of 1.1. Further, lubricating oils used in Comparative examples 8-1 to 8-6 contained Mo-DTC in a manner such that the molybdenum contents in the lubricating oils became 0 ppm, 300 ppm, 400 ppm, 700 ppm, 800 ppm, and 900 ppm, respectively. Also, as with the case of Example 7, a frictional wear test was conducted so as to determine the friction coefficient and the wear volume in Comparative examples 8-1 to 8-6. In addition, Comparative example 8-4 was conducted under the same conditions as in Example 1. The results are shown in table 4 and figs. 4 and 5.

### [Comparative example 9]

### <Comparative examples 9-1 and 9-2>

Sliding members were produced as with the case of Example 7 and lubricating oils to be fed between them were provided. Comparative examples 9-1 and 9-2 were different from Example 7 in that lubricating oils used in Comparative examples 9-1 and 9-2 contained Mo-DTC in a manner such that the molybdenum contents in the lubricating oils became 0 ppm and 300 ppm, respectively. Also, as with the case of Example 7, a frictional wear test was conducted so as to determine the friction coefficient and the wear volume in Example 9-1 and 9-2. The results are shown in table 4 and table 4 and fig. 5.

### [Comparative example 10]

### <Comparative examples 10-1 and 10-2>

Sliding members were produced as with the case of Example 8 and a lubricating oil to be fed between them was provided. Comparative examples 10-1 and 10-2 were different from Example 8 in that the lubricating oils used in Comparative examples 10-1 and 10-2 contained Mo-DTC in a manner such that the molybdenum contents in the lubricating oils became 0 ppm and 300 ppm, respectively. Comparative examples 10-1 and 10-2 correspond to the aforementioned Comparative examples 6 and 7 in that order. The measurement results of the friction coefficient and wear volume are shown in table 4 and fig. 5.

### [Comparative example 11]

### <Comparative examples 11-1 to 11-6>

Sliding members were produced as with the case of Example 7 and a lubricating oil to be fed between them was provided. Comparative examples 11-1 to 11-6 were different from Example 7 in that an amorphous carbon film was formed by the unbalanced magnetron sputtering method (under the same deposition conditions as in Comparative example 2 above), resulting in a D to G band integrated intensity ratio in the Raman spectrum of 2.11. Further, the lubricating oils used in Comparative examples 11-1 to 11-6 contained Mo-DTC in a manner such that the molybdenum contents in the lubricating oils became 0 ppm, 300 ppm, 400 ppm, 700 ppm, 800 ppm, and 900 ppm, respectively. Also, as with the case of Example 7, a frictional wear test was conducted so as to determine the friction coefficient and the wear volume in Comparative examples 11-1 to 11-6. In addition, Comparative example 11-4 was conducted under the same conditions as in Comparative example 2. The results are shown in table 4 and figs. 4 and 5.

### [Comparative example 12]

### <Comparative examples 12-1 to 12-6>

Sliding members were produced as with the case of Example 7 and lubricating oils to be fed between them were provided. Comparative examples 12-1 to 12-6 were different from Example 7 in that an amorphous carbon film was formed by the plasma CVD method (under the same deposition conditions as in Comparative example 3 above), resulting in a D to G band integrated intensity ratio in the Raman spectrum of 4.53. Further, the lubricating oils used in Comparative examples 12-1 to 12-6 contained Mo-DTC in a manner such that the molybdenum contents in the lubricating oils became 0 ppm, 300 ppm, 400 ppm, 700 ppm, 800 ppm, and 900 ppm, respectively. Also, as with the case of Example 7, a frictional wear test was conducted so as to determine the friction coefficient and the wear volume in Comparative examples 12-1 to 12-6. In addition, Comparative example 12-4 was conducted under the same conditions as in Comparative example 3. The results are shown in table 4 and fig. 4.

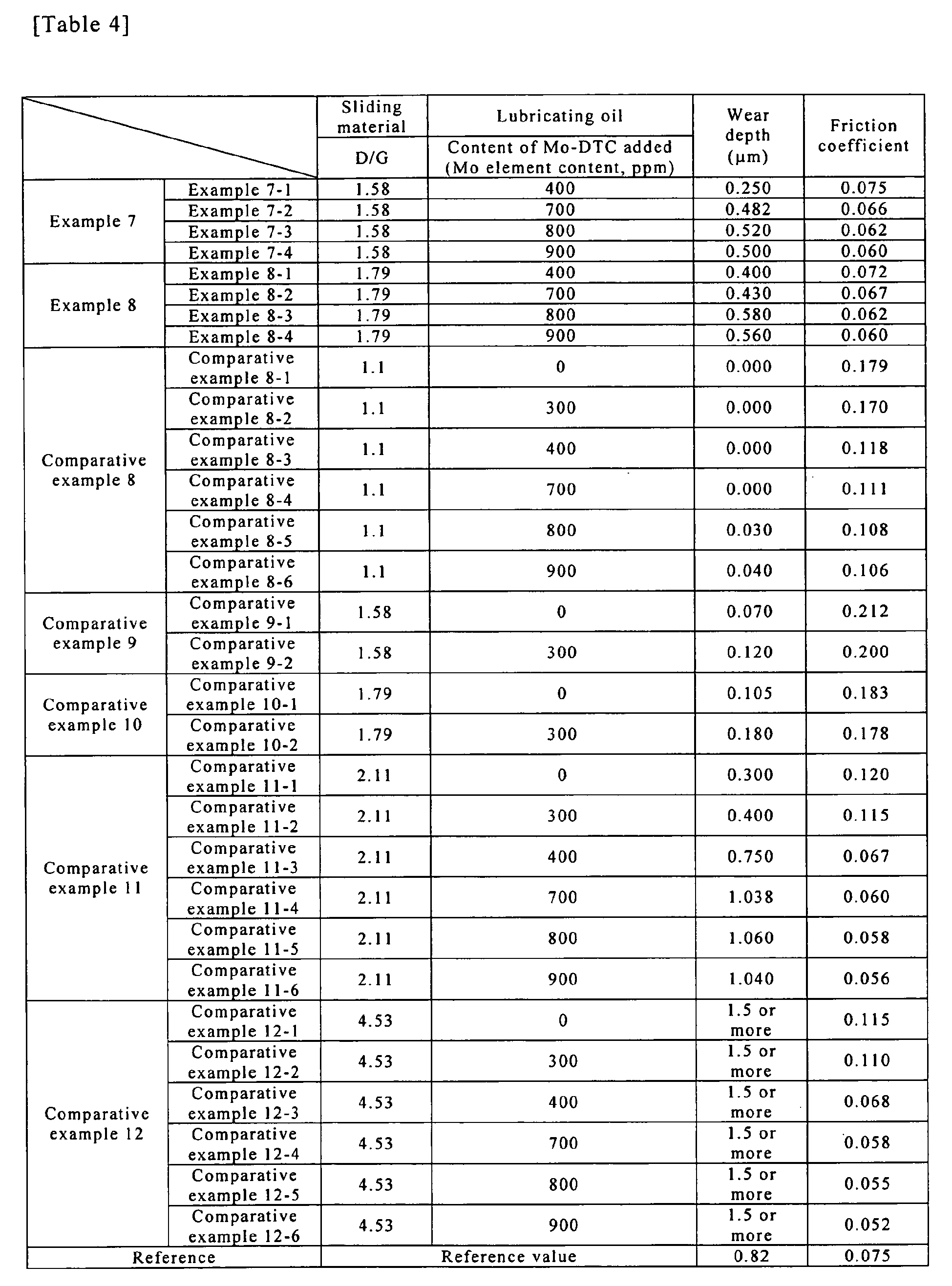

### [Result 3]

In the case of the sliding members of Examples 7 and 8, both wear depth and friction coefficient were below the respective reference values. However, in the cases of sliding members of Comparative examples 8 to 11, at least either wear depth or friction coefficient became larger than the reference value. Specifically, as shown in fig. 4, it was confirmed that the friction coefficient between the sliding members significantly declined when the molybdenum contents in the lubricating oils were between 300 ppm and 400 ppm and also when the D to G band integrated intensity ratio D/G was 1.5 or more. Further, as shown in fig. 5, it was confirmed that the wear depth value was lower than the reference value when the D to G band integrated intensity ratio D/G was not more than 2.0. Furthermore, as shown in fig. 4, it was confirmed that the friction coefficient did not significantly decline even when the molybdenum content in the compound was more than 800 ppm relative to the lubricating oil.

### [Evaluation 4]

Based on Result 3, it is considered that improved wear resistance and a decreased friction coefficient can be achieved when an amorphous carbon film has a D to G band integrated intensity ratio in the Raman spectrum of between 1.5 and 2.0 and a lubricating oil existing on sliding faces contains a compound comprising at least molybdenum and sulfur so as to result in a molybdenum content of not less than 400 ppm relative to the lubricating oil. For the purpose of cost reduction of lubricating oils, the preferred molybdenum content in a lubricating oil is not more than 800 ppm.

The sliding structure of the present invention is preferably used for a sliding part of an engine comprising a combination of a piston ring and a cylinder, for a sliding part of a cam lift comprising a combination of a cam and a cam follower, and for similar parts that are frequently allowed to slide under environments where wear resistance and low friction are required.

## Claims

1. A sliding structure in which a lubricating oil is fed between sliding faces of a pair of sliding members that are able to slide relative to each other such that at least one of the members is allowed to slide, **characterized in that**: an amorphous carbon film is formed on the sliding face of at least one sliding member so as to result in a D to G band integrated intensity ratio in the Raman spectrum of between 1.5 and 2.0; and the lubricating oil existing between the sliding faces contains a compound comprising at least molybdenum and sulfur so as to result in a molybdenum content of not less than 400 ppm relative to the lubricating oil.

2. The sliding structure according to claim 1, **characterized in that** the compound contained in the lubricating oil is selected from the group consisting of molybdenum dialkyldithiocarbamate (Mo-DTC), molybdenum dithiophosphate (Mo-DTP), molybdenum disulfide, and any combination thereof.

3. The sliding structure according to claim 1 or claim 2, **characterized in that** the compound is contained in the lubricating oil so as to result in the molybdenum content in the compound of not more than 800 ppm relative to the lubricating oil.

4. The sliding structure according to any one of claims 1 to 3, **characterized in that** the amorphous carbon film is formed by a plasma physical vapor deposition method (plasma PVD), a plasma chemical vapor deposition method (plasma CVD), or an arc ion plating method.

5. A sliding method wherein at least one member of a pair of sliding members is allowed to slide while a lubricating oil is fed between sliding faces of the sliding members, **characterized in that**:
an amorphous carbon film is formed on the sliding face of at least one sliding
member so as to result in a D to G band integrated intensity ratio in the Raman spectrum of between 1.5 and 2.0; and the lubricating oil contains a compound comprising at least molybdenum and sulfur so as to result in a molybdenum content of not less than 400 ppm relative to the lubricating oil.
